(19) Europäisches Patentamt
European Patent Office
Office européen des brevets

(11) EP 2 752 962 A1

(12) EUROPEAN PATENT APPLICATION
published in accordance with Art. 153(4) EPC

(43) Date of publication:
09.07.2014 Bulletin 2014/28

(51) Int Cl.:
H02J 7/00 (2006.01)　　B60L 11/18 (2006.01)
H01M 10/44 (2006.01)

(21) Application number: 12826906.5

(22) Date of filing: 31.08.2012

(86) International application number:
PCT/JP2012/072207

(87) International publication number:
WO 2013/031963 (07.03.2013 Gazette 2013/10)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 31.08.2011 JP 2011189386

(71) Applicant: TOYOTA JIDOSHA KABUSHIKI
KAISHA
Toyota-shi, Aichi-ken, 471-8571 (JP)

(72) Inventors:
• MORI Kenji
Toyota-shi
Aichi 471-8571 (JP)

• SHIGA Takahiro
Nagakute-shi
Aichi 480-1192 (JP)
• MORI Hiroko
Nagakute-shi
Aichi 480-1192 (JP)

(74) Representative: Winter, Brandl, Fürniss, Hübner,
Röss, Kaiser, Polte - Partnerschaft
Patent- und Rechtsanwaltskanzlei
Alois-Steinecker-Strasse 22
85354 Freising (DE)

(54) CHARGE/DISCHARGE ASSIST DEVICE

(57)　An electronic control unit 11 of a charge/discharge assist device 10 has a data input section 51, a departure/arrival time prediction map generation section 52, a travel distance prediction map generation section 53, a rule curve creation section 54, and a data output section 55. The input section 51 inputs departure time information, arrival time information, and travel distance information. The prediction map generation section 52 creates a map for providing a predicted departure time in future and a map for providing a predicted arrival time in future. The prediction map generation section 53 creates a departure-time-zone-specific predicted travel distance map for predicting the longest travel distance in each departure time zone, by using the travel distance information and predicted departure time information. On the basis of the predicted travel distance map, the creation section 54 determines an electric energy required in each time zone and creates a rule curve. The output section 55 creates a charge plan or a discharge plan by using the rule curve and outputs the plan.

FIG.3

EP 2 752 962 A1

**Description**

TECHNICAL FIELD

The present invention relates to a charge/discharge assist device which assists charge or discharge of a battery installed in equipment.

BACKGROUND ART

A charge/discharge management apparatus as disclosed in, for example, Patent Document 1 listed below has been conventionally known. This conventional charge/discharge management apparatus includes charge/discharge reward information receiving means for receiving from a charge management central server charge/discharge reward information that defines a reward which each consumer can receive in accordance with the charge/discharge behavior of the consumer and restrictions on implementation of charge and discharge; a calculation section for creating, on the basis of the charge/discharge reward information, a charge/discharge plan which includes a total charge amount and a total discharge amount in a certain time zone and an estimated time at which use of an electric vehicle starts such that the reward becomes maximum; charge/discharge command transmitting means for instructing the electric vehicle to start and end charge and discharge in accordance with the charge/discharge plan; charge/discharge amount monitoring means for monitoring charge and discharge; and charge/discharge implementation result transmitting means for transmitting to the charge management central server the charge/discharge implementation result which includes details on charge/discharge (obtained through monitoring) and individual identification information (for identifying the charge/discharge management apparatus itself). Thus, it becomes possible to improve the energy consumption performance of the entire power system and the social environmental performance in consideration of the behavior of consumers.
Also, an electric vehicle charge system and an electric vehicle charge method as disclosed in, for example, Patent Document 2 listed below have been conventionally known. These conventional electric vehicle charge system and electric vehicle charge method are designed such that, when the electric vehicle stops in a parking space, a control apparatus 10 communicates with the electric vehicle via a changeover switch to acquire a vehicle ID, a remaining battery energy, travel information, etc., predicts the stay time of a customer identified from the vehicle ID by use of a neural network technique or the like, calculates a charge time from the remaining battery energy and the charge speed of a charger, thereby creating a charge schedule such that the charge time becomes shorter than the stay time. Also, the above-described conventional electric vehicle charge system and the electric vehicle charge method are designed such that, when the calculated charge time is longer than the stay time, the control apparatus 10 calculates from the travel information the amount of charge required for a return travel, and calculates the charge time again. In the case where the amount of charge is insufficient, the control apparatus 10 outputs an alarm indicating to that effect or a message prompting the customer to postpone the departure time. Thus, a plurality of electric vehicles can be charged efficiently.
Further, a power management system as disclosed in, for example, Patent Document 3 listed below has been conventionally known. The conventional power management system includes a reserved power energy calculation section. The reserved power energy calculation section learns the power energy consumed per trip, which is acquired by a travel history acquiring apparatus, in order to calculate a basic electric energy necessary for ordinary travel. Furthermore, the reserved power energy calculation section determines a reserved power energy by adding a power energy necessary for use of an air conditioner or the like on the basis of weather information from a weather information detection section. Thus, it is possible to reserve in an onboard battery a power energy corresponding to the travel environment, and cope with sudden going out.

PRIOR ART DOCUMENTS

PATENT DOCUMENTS

Patent Document 1: Japanese Patent Application Laid-Open (*kokai*) No. 2010-81722
Patent Document 2: Japanese Patent Application Laid-Open *(kokai)* No. 2011-83165
Patent Document 3: Japanese Patent No. 4164996

SUMMARY OF THE INVENTION

Incidentally, in the conventional apparatus and systems disclosed in Patent Documents 1 to 3, a travel start time and a travel start distance are predicted from a past power consumption. However, in order to allow the user to use equipment (including a vehicle) having a battery more conveniently and reliably, electric energy necessary for the user to run the vehicle (operate the equipment) must have been stored in the battery before a predetermined time (time zone), or an excessive electric energy must have been discharged from the battery by the time (time zone) the user causes the vehicle to travel (operates the equipment). For this purpose, it is necessary to accurately predict a state of use of the vehicle; in other words, lifestyle of the user, in order to create a charge/discharge plan which reflects the state of use of the vehicle.

The present invention has been accomplished in order to solve the above-described problem, and its objects is to provide a charge/discharge assist device which grasps power consumption of a vehicle at individual times in order to perform charge/discharge control.

In order to achieve the above-described object, the present invention provides a charge/discharge assist device comprising control means for assisting charge or discharge of a battery installed in a piece of equipment, the charge/discharge assist device being characterized in that the control means acquires information concerning past consumption of power of the battery in the equipment, creates a rule curve representing a relation between time and an estimated necessary electric energy at each point in time which must be reserved before that time on the basis of the acquired information concerning the past consumption of power of the battery in the equipment, estimates and determines a charge start time at which charge of the battery is to be started or a discharge stop time at which discharge of the battery is to be stopped, by use of the created rule curve, and outputs the estimated and determined charge start time or discharge stop time. Notably, in this case, the control means may comprise input means for acquiring and inputting information concerning the past consumption of power of the battery in the equipment; rule curve creation means for creating the rule curve representing the relation between time and an estimated necessary electric energy at each point in time which must be reserved before that time on the basis of the information which is input by the input means and concerns the past consumption of power of the battery in the equipment, and output means for estimating and determining the charge start time at which charge of the battery is to be started or the discharge stop time at which discharge of the battery is to be stopped, by use of the rule curve created by the rule curve creation means and outputting the estimated and determined charge start time or discharge stop time.

In this case, for example, the control means may estimate and determine a latest charge start time which is a latest time at which charge of the battery is to be started or a latest discharge stop time which is a latest time at which discharge of the battery is to be stopped, by use of the created rule curve; specifically, by setting a line segment which is tangent to the rule curve in the vicinity of a point corresponding a local maximum value of the rule curve or a line segment whose value is always greater than the estimated necessary electric energy represented by the rule curve. Notably, in this case, by use of the rule curve created by the rule curve creation means, the output means may set a line segment which is tangent to the rule curve in the vicinity of a point corresponding to a local maximum value of the rule curve or a line segment whose value is always greater than the estimated necessary electric energy represented by the rule curve, to thereby estimate and determine the latest charge start time among charge start times at which charge of the battery is to be started or the latest discharge stop time among discharge stop times at which discharge of the battery is to be stopped.

Furthermore, in this case, for example, when the created rule curve has a plurality of local maximum values, the control means may set line segments each of which is tangent to the rule curve in the vicinity of a point representing the corresponding local maximum value or line segments each of which has a value which is always greater than the estimated necessary electric energy represented by the rule curve, estimate and determine latest charge start times or latest discharge stop times by using the line segments, and output the earliest one of the latest charge start times or the latest one of the latest discharge stop times. Notably, in this case, when the rule curve created by the rule curve creation means has a plurality of local maximum values, the output means may set line segments each of which is tangent to the rule curve in the vicinity of a point representing the corresponding local maximum value or line segments each of which has a value which is always greater than the estimated necessary electric energy represented by the rule curve, estimate and determine latest charge start times or latest discharge stop times by using the line segments, and output the earliest one of the latest charge start times or the latest one of the latest discharge stop times.

In the above-described cases, for example, when the estimated power consumption represented by the created rule curve exceeds the upper limit of the battery capacity of the battery, the control means may set a line segment that passes through a point at which the estimated necessary electric energy coincides with the upper limit of the battery capacity or a line segment whose value is always greater than the estimated necessary electric energy represented by the rule curve, to thereby estimate and determine the latest charge start time. Alternatively, the control means may set a line segment which passes through the above-described point or a line segment whose value is always greater than the estimated necessary electric energy represented by the rule curve, to thereby estimate and determine the latest discharge stop time. Notably, in this case, when the estimated power consumption represented by the rule curve created by the rule curve creation means exceeds the upper limit of the battery capacity of the battery, the output means may set a line segment that passes through a point at which the estimated necessary electric energy coincides with the upper limit of the battery capacity or a line segment whose value is always greater than the estimated necessary electric energy represented by the rule curve, to thereby estimate and determine the latest charge start time. Alternatively, the output means may set a line segment which passes through the above-described point or a line segment whose value is always greater than the estimated necessary electric energy represented by the rule curve, to thereby estimate and determine the latest discharge stop time.

Further, in the above-described cases, the control means may set the line segment for estimating and determining the latest charge start time by use of at least one of an amount of electric energy that can be stored in the battery, a predicted ambient temperature at the time when the battery is charged, a charge voltage supplied to the battery, and a charge current supplied to the battery. Alternatively, the control means may set the line segment for estimating and determining the latest discharge stop time by use of at least one of the amount of electric energy that can be discharged from the battery, a predicted ambient temperature at the time when the battery is discharged, a discharge voltage supplied from the battery, and a discharge current supplied from the battery. Notably, in this case, the output means may set the line segment for estimating and determining the latest charge start time by use of at least one of the amount of electric energy that can be stored in the battery, the predicted ambient temperature at the time when the battery is charged, the charge voltage supplied to the battery, and the charge current supplied to the battery. Alternatively, the output means may set the line segment for estimating and determining the latest discharge stop time by use of at least one of the amount of electric energy that can be discharged from the battery, the predicted ambient temperature at the time when the battery is discharged, the discharge voltage supplied from the battery, and the discharge current supplied from the battery.

Another feature of the present invention resides in that the equipment is a plug-in-type electric vehicle whose battery is charged by an external power supply, and the control means creates a rule curve representing a relation between time and an estimated necessary electric energy at each point in time which must be reserved before that time on the basis of the information concerning the past consumption of power of the battery in the plug-in-type electric vehicle. Notably, in this case, the rule curve creation means may create a rule curve representing a relation between time and an estimated necessary electric energy at each point in time which must be reserved before that time on the basis of the information concerning the past consumption of power of the battery which is installed in the plug-in-type electric vehicle and which is charged by an external power supply.

In this case, the information concerning the past consumption of power of the battery in the plug-in-type electric vehicle may be either one of the following two pieces of information, for example, information which further includes departure time information indicating a time at which the plug-in-type electric vehicle departed from a predetermined parking position and arrival time information indicating a time at which the plug-in-type electric vehicle arrived at the predetermined parking position; and travel distance information indicating the travel distance that the plug-in-type electric vehicle has traveled after it departed from the predetermined parking position at the departure time indicated by the departure time information.

Another feature of the present invention resides in that the control means creates rule curves for a plurality of pieces of equipment, each of which represents a relation between time and an estimated necessary electric energy at each point in time which must be reserved before that time, on the basis of information concerning the past consumption of power of the battery in each of the plurality of pieces of equipment, estimates and determines a charge start time at which charge of the battery is to be started or a discharge stop time at which discharge of the battery is to be stopped, by use of the created rule curves and in consideration of the priority among the plurality of pieces of equipment when they are used, and outputs the estimated and determined charge start time or discharge stop time. In this case, in consideration of the priority among the plurality of pieces of equipment, the control means may set line segments each of which is tangent to the created rule curve in the vicinity of a point corresponding to a local maximum value of the rule curve or line segments each of which has a value which is always greater than the estimated necessary electric energy represented by the rule curve, to thereby estimate and determine the latest charge start time or the latest discharge stop time. Notably, in this case, the rule curve creation may create rule curves for the plurality of pieces of equipment, each of which represents a relation between time and an estimated necessary electric energy at each point in time which must be reserved before that time, on the basis of the information concerning the past consumption of power of the battery. Further, by use of the rule curves created by the rule curve creation means, the output means may estimate and determine, a charge start time at which charge of the battery is to be started or a discharge stop time at which discharge of the battery is to be stopped, in consideration of the priority to be applied when the plurality of pieces of equipment are used, to thereby output the estimated and determined charge start time or discharge stop time. In this case, in consideration of the priority to be applied when the plurality of pieces of equipment are used, the rule curve creation means may set line segments each of which is tangent to the created rule curve in the vicinity of a point corresponding to a local maximum value of the rule curve or line segments each of which has a value which is always greater than the estimated necessary electric energy represented by the rule curve, to thereby estimate and determine the latest charge start time or the latest discharge stop time.

By virtue of these features, the control means (rule curve creation means) of the charge/discharge assist device can accurately estimate and determine a rule curve representing the relation between time and an estimated necessary electric energy at each point in time on the basis of the information concerning the past consumption of power of equipment including the plug-in-type electric vehicle whose battery is charged by an external power supply. Further, on the basis of the rule curve created through accurate estimation, the control means (output means) of the charge/discharge assist device can determine and output, for example, a charge start time at which charge of the battery must be started in order to complete the charge of the battery before coming of a time zone (time) where the estimated necessary electric energy required for operating the equipment (running the vehicle) becomes maximum. Further, on the basis of the rule curve created through accurate estimation, the control means

(output means) of the charge/discharge assist device can determine and output, for example, a discharge stop time until which an electric energy can be discharged from the battery, for example, in the case where the battery has excessive power. Thus, the user can grasp extremely accurate information and certainly control charge and discharge of the battery of the vehicle. Accordingly, the user of equipment (vehicle) which is a target for such charge/discharge assist can reliably use the equipment (vehicle) with the battery maintained in a good charge condition, thereby enjoying extremely high convenience.

BRIEF DESCRIPTION OF THE DRAWINGS

FIG. 1 is a schematic diagram showing the configuration of a system to which a charge/discharge assist device according to the present invention can be applied.

FIG. 2 is a schematic diagram showing the configuration of the charge/discharge assist device according to the present invention.

FIG. 3 is a functional block diagram showing functions which are realized by computer program processing in an electronic control unit shown in FIG. 2.

FIG. 4 is a diagram used for describing a predicted departure time map and a predicted arrival time map which are created by a departure/arrival time prediction map generation section shown in FIG. 3.

FIG. 5 is a diagram used for describing a departure-time-zone-specific predicted travel distance map created by a travel distance prediction map generation section shown in FIG. 3.

FIG. 6 is a diagram used for describing travel distance cumulative frequency distributions in individual time zones which are obtained through approximation by Weibull distribution.

FIG. 7 is a schematic diagram showing a rule curve created by a rule curve creation section shown in FIG. 3.

FIG. 8 is a diagram used for describing how a data output section shown in FIG. 3 determines an estimated latest charge start time and an estimated latest discharge stop time by a data output section shown in FIG. 3.

FIG. 9 is a diagram which relates to a first modification of the present invention and which is used for describing how the data output section determines the latest charge start time and the estimated latest discharge stop time by use of a rule curve having a plurality of local maximum values.

FIG. 10 is a diagram which relates to a second modification of the present invention and which is used for describing how the data output section determines the latest charge start time and the estimated latest discharge stop time by use of a rule curve in which the estimated necessary electric energy exceeds the upper limit of the battery capacity.

FIG. 11 is a diagram which relates to a third modification of the present invention and which is used for describing how the data output section determines the latest charge start time by use of a plurality of rule curves and priority among a plurality of pieces of equipment.

BEST MODE FOR CARRYING OUT THE INVENTION

Hereinafter, a charge/discharge assist device according to an embodiment of the present invention will be described with reference to the drawings.

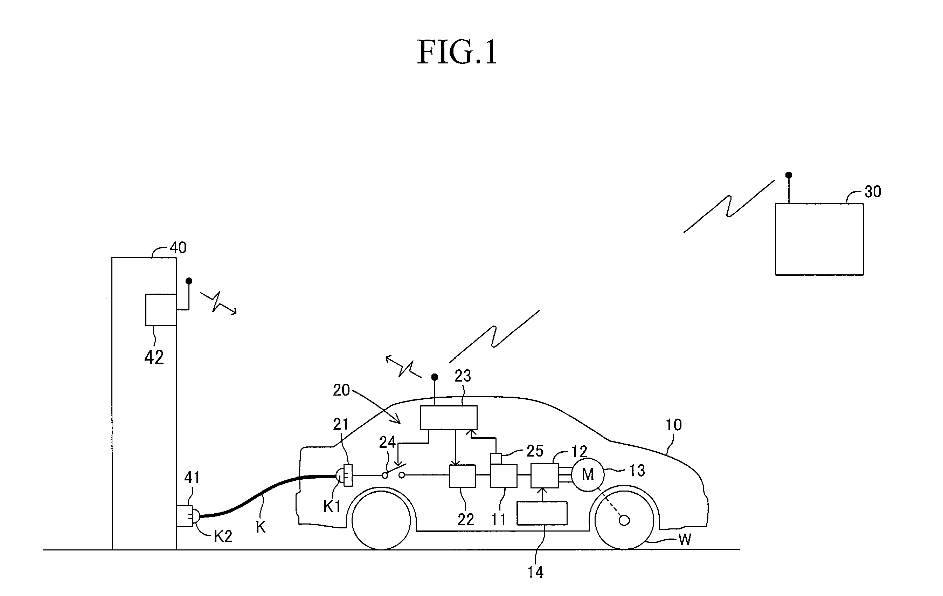

FIG. 1 schematically shows the configuration of a system to which the charge/discharge assist device can be applied. A vehicle 10 constituting this system is a plug-in-type electric vehicle including a battery 11 which can be charged from an external power supply. Examples of the plug-in-type electric vehicle include an electric vehicle (EV) driven by electric power of the battery 11 and a plug-in-type hybrid vehicle (PHV) which includes an internal combustion engine in addition to the battery 11. Another example of the plug-in-type electric vehicle is a plug-in-type two-wheeled vehicle (e.g., an electric bicycle, an assisted bicycle, or an electric bike). Notably, since the vehicle 10 can adopt a well-known configuration and this configuration does not directly relate to the present invention, the configuration will be briefly described below.

As shown in FIG. 1, the vehicle 10 includes, as components of a travel drive system, an inverter 12 which converts DC power output from the battery 11 to three-phase AC power; a traction motor 13 which is driven by the three-phase AC power output from the inverter 12 and which rotates wheels W; and a motor control unit 14 which controls the output of the inverter 12. Thus, the motor control unit 14 controls the power supplied from the battery 11 to the traction motor 13 via the inverter 12, to thereby run the vehicle 10.

The vehicle 10 includes a charge/discharge system 20 for charging or discharging the battery 11. As shown in FIG. 1, the charge/discharge system 20 includes a power reception/supply connector 21 provided such that a plug K1 of a charge/discharge cable K can be connected thereto; an ACIDC converter 22 which converts AC power fed to the power reception/supply connector 21 to DC power in order to output DC power to the battery 11 and which converts the DC power charged in the battery 11 to AC power in order to output the AC power to the charge/discharge cable K via the power reception/supply connector 21; and a vehicle-side charge/discharge control unit 23 which controls charge and discharge of the battery 11 (hereinafter simply referred to as a "vehicle-side charge/discharge ECU 23"). The vehicle-side charge/discharge ECU 23 is a microcomputer which is mainly composed of a CPU, a ROM, a RAM, etc. As shown in FIG. 1, the vehicle-side charge/discharge ECU 23 can communicate with a charge/discharge assist device 30 via a communication antenna. In the charge/discharge system 20, a charge/discharge control switch 24 is provided in a power supply line between the power reception/supply connector 21 and the AC/DC converter 22. The state of the charge/discharge control switch 24 can be switched between the ON state and the OFF state by control signals output from the vehicle-side charge/discharge ECU 23. Furthermore, in the charge/discharge system 20, there is provided an SOC detection section 25 which is provided on the battery 11 in order to detect an SOC (State of Charge) which is a value indicating the charge state of the battery 11 (an electrical energy or a remaining battery energy). The SOC detection section 25 outputs a signal representing the SOC to the vehicle-side charge/discharge ECU 23.

When the vehicle 10 including the above-described charge system 20 is electrically connected to a charge/discharge socket 41 of a charge/discharge station 40 which is a charge/discharge facility installed at a predetermined parking position such as premises of the user or a shared parking lot, power is supplied to the battery 11 to charge it or power of the battery 11 is discharged to the charge/discharge station 40. Specifically, when charging or discharging the battery 11 of the vehicle 10, the user inserts a plug K2 of the charge/discharge cable K into the charge/discharge socket 41 and, as described above, the user inserts the plug K1 of the charge/discharge cable K into the power reception/supply connector 21. Thus, when the battery 11 of the vehicle is charged, power is supplied from the charge/discharge socket 41 to the battery 11 of the vehicle 10. On the other hand, when the battery 11 of the vehicle 10 is discharged, power is supplied from the battery 11 of the vehicle 10 to the charge/discharge socket 41.

The charge/discharge station 40 includes a power reception/supply control unit 42 (hereinafter referred to as a "power reception/supply ECU 42"). The power reception/supply ECU 42 is a microcomputer which is mainly composed of a CPU, a ROM, a RAM, etc. As shown in FIG. 1, the power reception/supply ECU 42 performs short-range radio communication with the vehicle-side charge/discharge ECU 23 of the charge/discharge system 20 via a communication antenna, to thereby receive or supply an appropriate amount of power. Namely, the power reception/supply ECU 42 sends to and receives from the vehicle-side charge/discharge ECU 23 various pieces of information (e.g., a request code and a response code relating to charge, ID information for identifying the vehicle 10 (i.e., the user), SOC of the battery 11, etc.) at predetermined intervals, to thereby receive or supply an appropriate amount of power. In other words, the power reception/supply ECU 42 is adapted to charge and discharge the battery 11 appropriately.

The charge/discharge assist device 30 (hereinafter also referred to as the "present apparatus 30") collects and accumulates, as a daily behavior pattern (lifestyle) of the user of the vehicle 10, times of departure of the vehicle 10 from a predetermined parking position where the vehicle 10 is parked, times of arrival of the vehicle 10 at the predetermined parking position, and distances that the vehicle 10 has traveled until the vehicle 10 arrives at (returns to) the predetermined parking position since the vehicle 10 departed from the predetermined parking position. The charge/discharge assist device 30 accurately predicts the state of daily use of the vehicle 10 (more specifically, the state of use of the vehicle 10 in each day of the week) from the accumulated behavior pattern of the vehicle 10. Subsequently, on the basis of the state of use of the vehicle 10 predicted as described above, the charge/discharge assist device 30 creates a rule curve representing estimated necessary electric energies (remaining battery energies) at individual times (or in individual time zones). The charge/discharge assist device 30 determines an optimum charge start time or an optimum discharge stop time on the basis of the created rule curve.

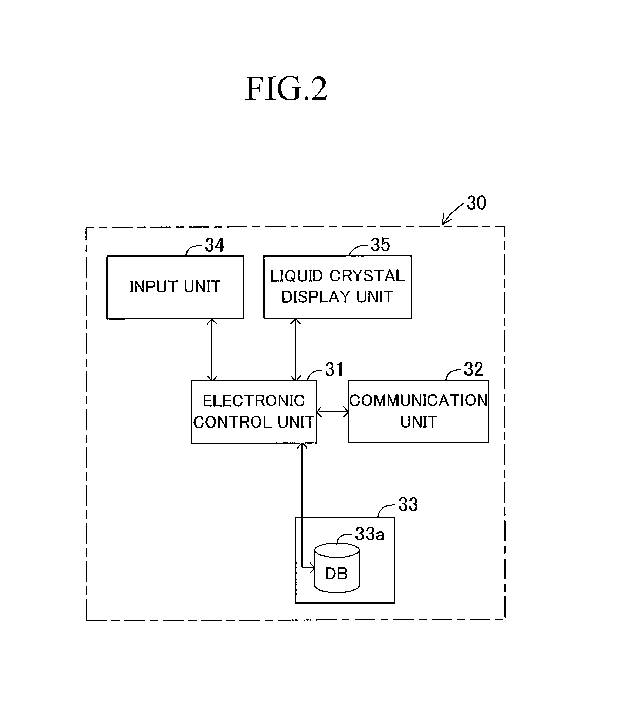

For this purpose, as schematically shown in FIG. 2, the present apparatus 30 includes, as minimum necessary components, an electronic control unit 31, a communication unit 32, and a storage unit 33 which are connected in a way they can communicate with one another. Accordingly, the configuration of the present apparatus 30 can be modified in accordance with the mode of use (mode of installation) thereof. For example, as shown in FIG. 2, the present apparatus 30 may include an input unit 34 and a liquid crystal display unit 35.

The electronic control unit 31 is a microcomputer which is mainly composed of a CPU, a ROM, and a RAM. By means of executing various programs, the electronic control unit 31 comprehensively controls operation of the present apparatus 30. The communication unit 32 performs wireless (or wired) communication with at least the vehicle-side charge/discharge ECU 23. Notably, the communication unit 32 communicates with the vehicle-side charge/discharge ECU 23 in different ways depending on the mode of use (installation) of the present apparatus 30. In the case where the predetermined parking position of the vehicle 10 is, for example, premises of the user and the present apparatus 30 is used there; namely, the present apparatus 30 is used at a position which is relatively close to the vehicle 10, the communication unit 32 can directly communicate with the vehicle-side charge/discharge ECU 23 through short-range wireless communication (or wired communication). In the case where the present apparatus 30 is installed and used at a position which is distant from the predetermined parking position, the communication unit 32 can communicate with the vehicle-side charge/discharge ECU 23 through wireless communication (or wired communication) performed via, for example, the Internet (public network) or a dedicated network.

The storage unit 33 includes a storage medium, such as a hard disk or a semiconductor memory, and a drive unit for driving the storage medium. The storage unit 33 prestores a program and data that the electronic control unit 31 requires in order to comprehensively control operation of the present apparatus 30. In the storage unit 33, there is built a vehicle travel history database 33a which searchably stores the travel history of the vehicle 10; i.e., information concerning the past power consumption of the vehicle 10. Notably, in the storage unit 33, for example, there can be built as needed a vehicle ID database which searchably stores, for example, vehicle registration numbers and chassis numbers as ID information for identifying the vehicle 10 (vehicle ID information) and/or a user ID database which searchably stores ID information for identifying the user of the vehicle 10 (user ID information).

The input unit 34 includes operation switches provided in the vicinity of the liquid crystal display unit 35, panel touch switches which are incorporated in the liquid crystal display unit 35 in order to detect display panel touch operations performed by the user, thereby allowing the user to input various kinds of data. The liquid crystal display unit 35 displays characters, graphics, etc. on the display panel thereof.

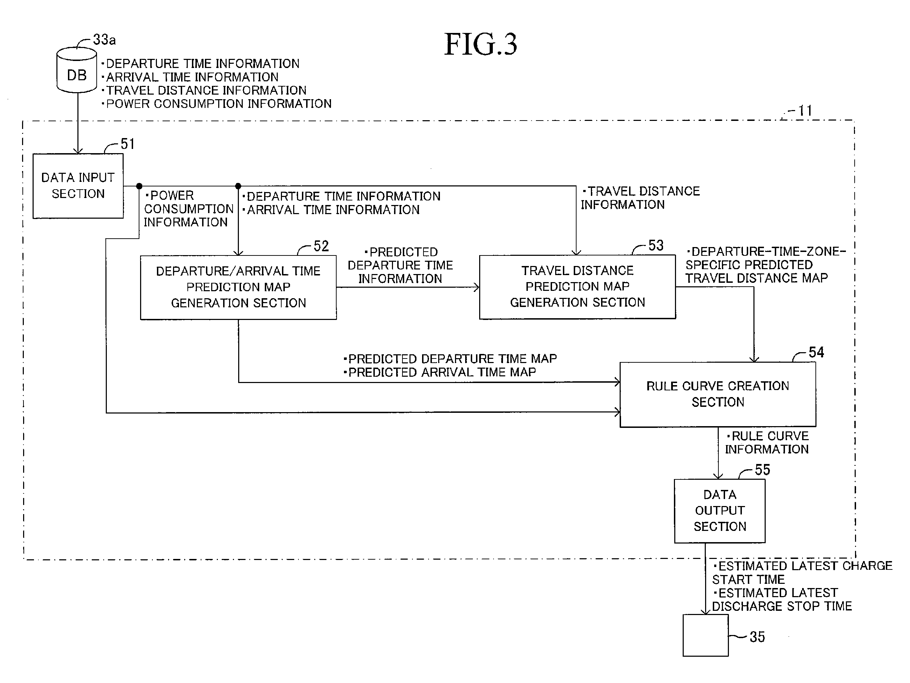

Next, operation of the present apparatus 30 configured as described above will be described with reference to the functional block diagram of FIG. 3 which shows the functions realized by the processing performed by a computer program in the electronic control unit 31. The electronic control unit 31 of the present apparatus 30 of the present embodiment includes a data input section 51, a departure/arrival time prediction map generation section 52, a travel distance prediction map generation section 53, a rule curve creation section 54, and a data output section 55.

Notably, in the present embodiment, in order to create a rule curve for the vehicle 10 which is a target for charge/discharge assist, the present apparatus 30 uses the travel history of the vehicle 10. For this purpose, the vehicle 10 of the present embodiment can detect a time of departure from a predetermined parking position (e.g., premises of the user) (also referred to as a starting position) where a charge/discharge station 40 available for charge/discharge is installed, a time of arrival at (return to) this predetermined parking position, and a distance that the vehicle 10 has traveled until the vehicle 10 arrives at (returns to) the predetermined parking position since the vehicle 10 started the predetermined parking position. In this case, any method may be adopted in order to detect the above-described departure time, arrival time, and travel distance. For example, preferably, the vehicle 10 is equipped with a well-known navigation unit. This navigation unit detects the current position of the vehicle 10. Thus, the departure time, the arrival time, and the travel distance can be detected with the above-described predetermined parking position used as a starting point. Alternatively, by means of directly acquiring the current position of the vehicle 10 through communication, the present apparatus 30 can detect (acquire) the departure time, arrival time, and travel distance of the vehicle 10.

When the user starts a travel of the vehicle 10 from (departs from) the predetermined parking position, for example, the navigation unit installed in the vehicle 10 detects, on the basis of a change in the detected current position of the vehicle 10, that the vehicle 10 has departed from the predetermined parking position, and stores departure time information representing the time of detection of the departure (i.e., the departure time) in a predetermined storage means along with the vehicle ID. In addition, the navigation unit installed in the vehicle 10 calculates the distance that the vehicle 10 has traveled after the departure on the basis of the change in the detected current position of the vehicle 10, and finally stores in the predetermined storage means travel distance information representing the distance that the vehicle 10 driven by the user has traveled until the vehicle 10 arrives at (returns to) the predetermined parking position along with the vehicle ID and the departure time information. Subsequently, the navigation unit installed in the vehicle 10 detects that the vehicle 10 has arrived at the predetermined parking position on the basis of the change in the detected current position of the vehicle 10, and stores in the predetermined storage means arrival time information representing the time of detection of the arrival (i.e., the arrival time) along with the vehicle ID, the departure time information, and the travel distance information. Furthermore, the vehicle-side charge/discharge ECU 23 of the charge/discharge system 20 of the vehicle 10, in cooperation with the navigation units, stores power consumption information in the predetermined storage means along with the vehicle ID. The power consumption information represents the travel distance per unit amount of electric energy stored in the battery 11, for example, during the present travel (so-called power consumption). In addition, when the vehicle 10 is parked in the predetermined parking position, the vehicle-side charge/discharge ECU 23 of the charge/discharge system 20 outputs to the present apparatus 30 the vehicle ID, the departure time information, the arrival time information, and the travel distance information, which are stored in the storage means. In addition, the vehicle-side charge/discharge ECU 23 outputs the power consumption information to the present apparatus 30.

In the present apparatus 30, the electronic control unit 31 receives, via the communication unit 32, the vehicle ID, the departure time information, arrival time information, travel distance information, and power consumption information which have been output from the vehicle 10 that has completed a travel. Next, the electronic control unit 31 identifies the vehicle 10 by use of the received vehicle ID. Subsequently, the electronic control unit 31 stores the received departure time information, arrival time information, and travel distance information in the travel history database 33a. At that time, the electronic control unit 31 searchably accumulates (stores) the departure time information, the arrival time information, and the travel distance information, with them sorted by, for example, day of the week, in a storage area corresponding to the vehicle 10 which has been formed in advance in the vehicle travel history database 33a. The electronic control unit 31 also stores the power consumption information in combination with these three pieces of information.

After the departure time information, arrival time information, travel distance information, and power consumption information of the vehicle 10 have been stored as described above in the travel history database 33a of the storage unit 33 with them sorted by day of the week, the data input section 51 constituting the electronic control unit 31 retrieves from the vehicle travel history database 33a the departure time information, the arrival time information, the travel distance information, and the power consumption information. Hereunder, this processing will be described specifically on the basis of examples. The data input section 51 can selectively receive a plurality of pieces of departure time information, a plurality of pieces of arrival time information, a plurality of pieces of travel distance information, and a plurality of pieces of power consumption information of, for example, weekdays (Monday to Friday) among the plurality of pieces of departure time information, the plurality of pieces of arrival time information, the plurality of pieces of travel distance information, and the plurality of pieces of power consumption information of the vehicle 10, which are stored in the travel history database 33a. Alternatively, the data input section 51 can selectively retrieve a plurality of pieces of departure time information, a plurality of pieces of arrival time information, a plurality of pieces of travel distance information, and a plurality of pieces of power consumption information for, for example, holidays (i.e., Saturday and Sunday) or national holidays among the plurality of pieces of departure time information, the plurality of pieces of arrival time information, the plurality of pieces of travel distance information, and the plurality of pieces of power consumption information of the vehicle 10, which are stored in the travel history database 33a.

After retrieving the plurality of pieces of departure time information, the plurality of pieces of arrival time information, the plurality of pieces of travel distance information, and the plurality of pieces of power consumption information of the vehicle 10 which are sorted by day of the week, the data input section 51 outputs the plurality of pieces of departure time information and the plurality of pieces of arrival time information which are sorted by day of the week to the departure/arrival time prediction map generation section 52, outputs the plurality of pieces of travel distance information to the travel distance prediction map generation section 53, and outputs the plurality of pieces of power consumption information to the rule curve creation section 54.

The departure/arrival time prediction map generation section 52 generates, through use of the expression 1 given below, a predicted departure time map (for the vehicle 10) for weekdays and that for holidays and a predicted arrival time map (for the vehicle 10) for weekdays and that for holidays.

$$P_{tj} = \sum_{j=0}^{n} \frac{N_{tj}}{N_{All}} \quad \cdots (1)$$

Notably, in the expression 1 given above, $tj$ represents the $j$th (counted from the earliest one) departure time among the departure times represented by the plurality of pieces of departure time information retrieved from the data input section 51. Alternatively, $tj$ represents the $j$th (counted from the earliest one) arrival time among the arrival times represented by the plurality of pieces of arrival time information retrieved from the data input section 51. Further, in the expression 1 given above, $P_{tj}$ represents the cumulative probability of occurrence (safety probability) of the departure time $tj(j=0, \cdots n)$ or the arrival time $tj(j=0, \cdots n)$. Further, in the expression 1 given above, $N_{tj}$ represents the frequency of the departure time $tj(j=0, \cdots n)$ or the arrival time $tj(j=0, \cdots n)$, and $N_{All}$ represents the total frequency of the departure time $tj(j=0, \cdots n)$ or the arrival time $tj(j=0, \cdots n)$.

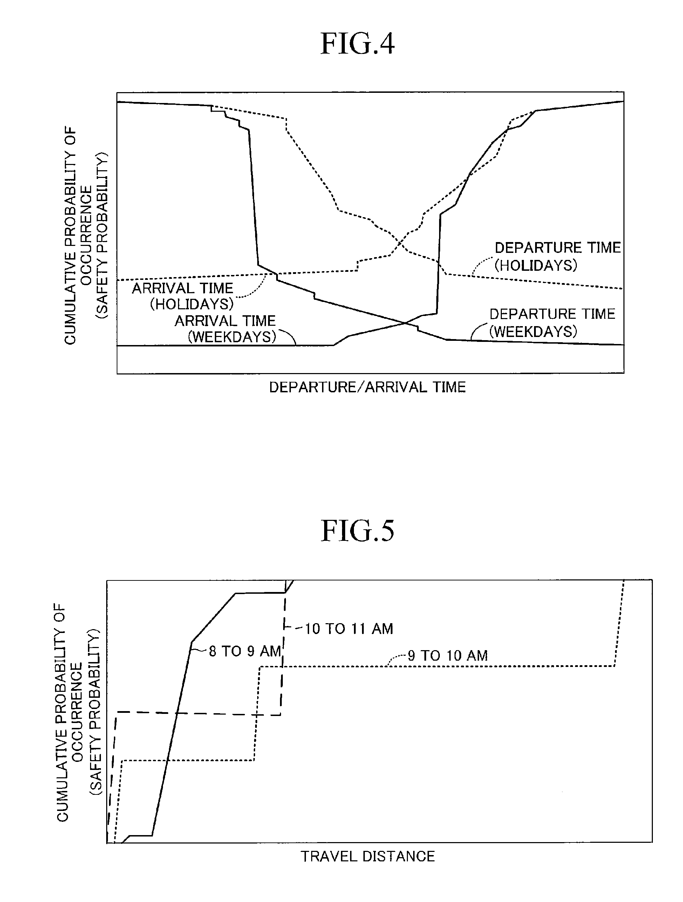

FIG. 4 shows a predicted departure time map for weekdays and that for holidays which are generated for, for example, the vehicle 10 in accordance with the expression 1 given above and a predicted arrival time map for weekdays and that for holidays which are also generated for, for example, the vehicle 10 in accordance with the expression 1 given above. The above-described predicted departure time maps and predicted arrival time maps show the following. As indicated by a solid line which shows departure times of the vehicle 10 on weekdays, it is highly probable that the vehicle 10 departs in a certain time zone (e.g., between eight and nine) on weekdays. Also, the above-described predicted departure time maps and predicted arrival time maps show the following. As indicated by a broken line which shows departure times of the vehicle 10 on holidays, the vehicle 10 departs almost evenly in all time zones on holidays. After generating the predicted departure time maps and the predicted arrival time maps as described above, the departure/arrival time prediction map generation section 52 supplies to the travel distance prediction map generation section 53 predicted departure times representing the departure times which are predicted from the generated predicted departure time maps among the created predicted departure time maps and predicted arrival time maps.

The travel distance prediction map generation section 53 receives from the data input section 51 the plurality of pieces of travel distance information of the vehicle 10 which are sorted by day of the week. Further, the travel distance prediction map generation section 53 receives the plurality of pieces of predicted departure time information from the departure/arrival time prediction map generation section 52. Subsequently, by use of the plurality of pieces of travel distance information and the plurality of pieces of predicted departure time information, the travel distance prediction map generation section 53 generates, in accordance with the expression 2 given below, departure-time-zone-specific predicted travel distance maps for weekdays and holidays which are used to predict the longest travel distances in individual departure time zones (i.e., departure times).

$$P_{hd} = \sum_{d=0}^{d\,max} \frac{N_{hd}}{N_h} \quad \cdots (2)$$

Notably, in the expression 2 given above, $P_{hd}$ represents the cumulative probability of occurrence (safety probability) of a departure time zone h and a distance d in this departure time zone h (hereinafter, referred to as a "distance time zone d"). Further, in the expression 2 given above, $N_{hd}$ represents the frequency of the departure time zone h and the distance time zone d, and $N_h$ represents the total frequency of the departure time zone h.

FIG. 5 shows the departure-time-zone-specific predicted travel distance map for weekdays which is generated for, for example, the vehicle 10 in accordance with the expression 2 given above. Notably, this map shows predicted travel distances in three departure time zones; namely, a time zone between eight and nine, a time zone between nine and ten, and a time zone between ten and eleven. If this departure-time-zone-specific predicted travel distance map is seen focusing on the time zone between nine and ten and the time zone between ten and eleven, which are departure time zones on weekdays, it can be understood that there is a possibility that the vehicle 10 travels a long distance in these time zones.

According to the predicted departure time map for weekdays (shown in FIG. 4) which is generated by the departure/arrival time prediction map generation section 52, it is highly possible that the vehicle 10 departs in the time zone between eight and nine as described above. That is, as for the vehicle 10, up to the time zone between eight and nine, there is collected a large quantity of data represented by the frequency of the distance time zone d; namely, the travel distance information. In the time zone between nine and ten and the time zones thereafter, there is collected an extremely small quantity of data represented by the frequency of the distance time zone d; namely, the travel distance information. In this case, since the cumulative probability of occurrence (safety probability) $P_{hd}$ calculated in accordance with the expression 2 given above depends on $N_{hd}$; namely, the frequency of the departure time zone h and the distance time zone d, a map showing an unnatural distribution may be created in a situation where the frequency is extremely low (or the frequency is "0"). For example, such an unnatural distribution is seen in the time zone between nine and ten and the time zone between ten and eleven as shown in FIG. 5.

Incidentally, a distribution of a quantity assuming a positive value, such as travel distance, is often represented by an exponential family (e.g., exponential distribution, Weibull distribution, or gamma distribution) or log-normal distribution. Alternatively, such a distribution can be effectively represented by contaminated normal distribution, etc. Therefore, a departure-time-zone-specific predicted travel distance map can be generated in the following manner. When N pieces of data (($t_1$, $d_1$), ($t_2$, $d_2$), $\cdots$, and ($t_N$, $d_N$)) have been acquired, each piece of data indicating that the vehicle 10 started at a time t and traveled a distance d, a joint probability density function f(d,t) of the time t and the distance d) can be made from the N pieces of data. Notably, the joint probability density function f(d,t) of the time t and the distance d can also be represented by the product f(d,t) (=f(d|t)f(t)) of a probability density f(t) of departure at the time t and a probability density function f(d|t) with a condition that the vehicle 10 started at the time t travels the distance d. Methods of determining f(d,t) or determining f(t) and f(d|t)) from the above-mentioned data can be broadly classified into three methods as described below. These methods can be effectively used by appropriately divides data into pieces of data taking into account, for example, environment variables such as day of the week, season, temperature, climate, etc. and performing processing for each piece of data. Further, it is effective to collectively represent parameters for various environments by use of, for example, a generalized linear model by using the above-described environmental variables as qualitative variables.

a. Frequency method

A frequency method divides data in steps of a certain length of time (e.g., one hour), and represents in the form of a table a cumulative distribution of a plurality of pieces of data, each piece of data being represented by travel distance information of each time zone. In the frequency method, the cumulative distribution of a plurality of pieces of data, each piece of data being represented by the travel distance information in individual time zone, can be represented in the form of a table. This method is effective, because it is possible to hold an arbitrary distribution while reducing the calculation load. However, if the number of the pieces of data is small, the frequency method suffers disadvantages, for example, as shown in FIG. 5, only a stepwise, coarse distribution can be obtained, no distribution can be determined in time zones in which there is no data, or comparison with other distributions and tabulation become difficult because information cannot be collectively represented by a small number of parameters.

b. Non-parametric method

In order to solve the problem of the frequency method described in the paragraph under the title of "a. Frequency method" that a stepwise, coarse distribution is obtained, it is possible to adopt a non-parametric method in which no premise is given to the distribution pattern of a population. In this case, by adopting a method which does not assume a specific distribution pattern (e.g., kernel density estimation), an arbitrary distribution can be obtained in a smooth shape. However, even in the case where such a non-parametric method is adopted, it suffers from disadvantages such as difficulty in comparison with other distributions and totalization because information cannot be collectively represented by a small number of parameters.

c. Parametric method

It is possible to adopt a parametric method which makes some assumption in advance about the distribution pattern of a population unlike the non-parametric method described in the paragraph under the title of "b. Non-parametric method". Specifically, in this parametric method, the distribution f(d|t) in the direction of the travel distance is represented by a parametric probability distribution such as an exponential family (e.g., exponential distribution, Weibull distribution, or gamma distribution), log-normal distribution, or mixture Gaussian distribution, and its parameter is determined in each of steps of a certain length of time. Thus, a smooth distribution can be obtained in the direction of the travel distance. Notably, in this case, the distribution f(d|t) in the direction of the travel distance can be effectively represented by the sum of a plurality of distributions. Further, by giving prior distributions of parameters, parameters can be determined in accordance with the prior distributions even in the case where the number of pieces of data is small or "0" (zero). Notably, in the case where there has been accumulated a large quantity of information about parameters concerning the vehicle 10, the distribution of these parameters may be used as a prior distribution. Thus, by aggregating parameters for each of predetermined group, a rational prior distribution of parameters can be given to a new group in which the number of pieces of data is still "0" (zero). Further, the parameters of the new group are gradually corrected with an increase in the number of pieces of the data belonging to this group.

The parametric method will be described in more detail on the basis of an example. For example, in the case where a day is divided into 24 time zones (one hour each) and the parameter $a_t$ is obtained for each time zone (hourly) by use of the distribution presented by a parameter (vector) $a_t$ such that the expression $f(d|t)=g(d;a_t)$ is satisfied, there will be considered a prior distribution $p(a_0, \cdots, a_{23})$ for $a_0, \cdots, a_{23}$. In this case, the probability (likelihood) L that N pieces of data are observed from these parameters can be represented by the following expression 3.

$$L = \prod_i f(d_i \mid t_i) p(a_0,...,a_{23}) = \prod_i g(d_i; a_{t=ti}) p(a_0,...,a_{23}) \quad \cdots (3)$$

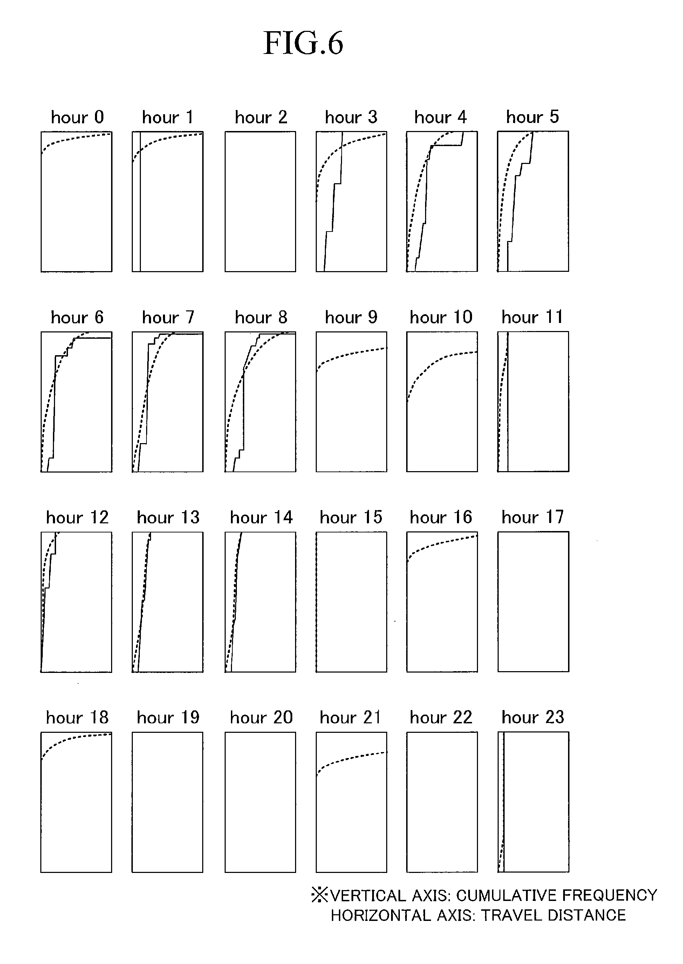

By means of maximizing the expression 3 given above with respect to $a_0, \cdots, a_{23}$, parameters can be determined as shown in, for example, FIG. 6.

In order to realize a smooth change between distance distributions in the adjacent time zones, a prior distribution $P(\Delta a_t)$ may be given such that the difference $\Delta a_t = a_t - a_{t+1}$ in parameter between the adjacent time zones is close to "0" (zero) or the ratio $\Delta a_t = a_t/a_{t+1}$ therebetween is close to "1." In this case, for example, as represented by the following expression 4, a normal distribution whose center of distribution is "0" (zero) or the like may be given as a prior distribution.

$$P(\Delta a_t) \propto \exp(-\Delta a_t{}^2) \quad \cdots (4)$$

When this parametric method is adopted, the parameter in a time zone, in which there is no data represented by travel distance information, is determined only by the prior distribution. Accordingly, by means of adopting, as a prior distribution, for example, a distribution showing that the average travel distance is nearly "0" and the parameter has the "maximum probability," a distribution of travel distance can be naturally selected such that the travel distance becomes nearly "0" (zero) in a time zones where there is no data represented by the travel distance information. Notably, when the parameter is determined as described above, it is possible to prevent the influence of accidentally generate data from lasting long, for example, by introducing a forgetting factor in order to give less weight to older data.

In this case, for example, the probability density of a distribution showing that the travel distance is nearly "0" (zero) can be represented by a delta function. Meanwhile, the Weibull distribution represented by the expression 5 given below can be made behave just like a delta function by setting the scale parameter T to a very small positive value.

$$f(t; m, T) = \frac{m}{T} * \left(\frac{t}{T}\right)^{m-1} * \exp\left(-\left(\frac{t}{T}\right)^m\right) \quad \cdots (5)$$

Notably, in the expression 5 given above, m represents the Weibull coefficient.

Specifically, the distribution represented by the following expressions 6 and 7 may be used as a prior distribution P(T) of the scale parameter T.

$$P(T) \propto \frac{1}{T} \quad \cdots (6)$$

$$P(T) \propto T^{m-1} \exp(-T) \quad \cdots (7)$$

Hereinafter, FIG. 6 will be described. FIG. 6 shows the results of approximation of travel distance cumulative frequency distributions in individual time zones by the Weibull distribution for the case where a gamma prior distribution is given to the parameter in the Weibull distribution. As is obvious from FIG. 6, when the data represented by actual travel distance information which is represented by a solid line is compared with the result of approximation by the Weibull distribution which is represented by a broken line, it can be understood that the travel distance cumulative frequency distribution is satisfactorily approximated by the Weibull distribution. In particular, FIG. 6 shows that, in time zones where there is no data represented by the travel distance information, the cumulative frequency sharply approaches "1" when the travel distance is close to "0" (zero), thereby appropriately showing that the travel distance is "0" (zero). Further, FIG. 6 shows the case where there are few (one or two) pieces of data represented by the travel information of long distance travel in the time zone between nine and ten and the time zone between ten and eleven. In this case, it can be understood that a cumulative distribution in which the travel distance sharply increases in the vicinity of "0" (zero) and thereafter increases slowly is obtained, because a restriction is imposed by the prior distribution such that the travel distance becomes "0" (zero).

If the distribution f(d|t) in the direction of the travel distance can be determined by use of the parametric method as described above, a cumulative frequency distribution F(d|t) for each departure time can be obtained by integrating this distribution f(d|t) with respect to the direction of the travel distance. A travel distance whose probability becomes equal to an arbitrary predetermined probability (hereinafter referred to as a "predetermined safety probability") in the cumulative frequency distribution F(d|t) for each departure time is obtained for each departure time. Thus, a travel distance which must be guaranteed can be obtained for each departure time and for each safety probability. Notably, needless to say, the above-described methods a to c may be combined in order to create the departure-time-zone-specific predicted travel distance maps for weekdays and holidays. After creating the departure-time-zone-specific predicted travel distance maps for weekdays and holidays by use of the travel distance information and the predicted departure time information, the travel distance prediction map generation section 53 supplies the departure-time-zone-specific predicted travel distance map to the rule curve creation section 54.

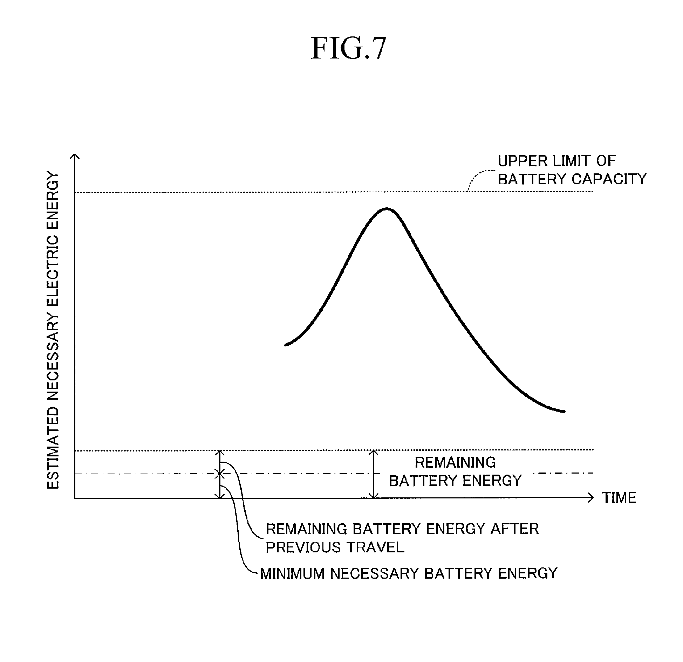

The rule curve creation section 54 retrieves from the data input section 51 the power consumption information of the vehicle 10. Also, the rule curve creation section 54 receives from the travel distance prediction map generation section 53 the departure-time-zone-specific predicted travel distance maps for weekdays and holidays. Subsequently, on the basis of the received departure-time-zone-specific predicted travel distance maps, the rule curve creation section 54 divides the travel distance predicted for each time zone by the power consumption of the vehicle 10 represented by the power consumption information in order to estimate and determine the electric energy (charge amount) required in the time zone concerned. Thus, the rule curve creation section 54 creates a rule curve (shown in FIG. 7) which represents a relation between time and an estimated necessary electric energy at each point in time which must be reserved before that time. After creating the rule curve corresponding to the vehicle 10 as described above, the rule curve creation section 54 supplies to the data output section 55 rule curve information representing the created rule curve.

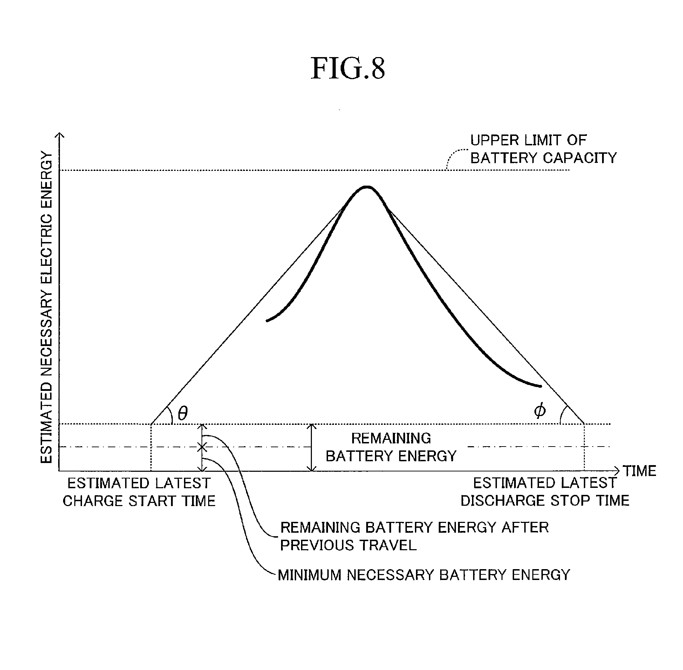

The data output section 55 acquires the rule curve information supplied from the rule curve creation section 54. Next, by use of the rule curve represented by the rule curve information, the data output section 55 accurately creates a charge plan for charging the battery 11 of the vehicle 10 or a discharge plan for discharging an electric energy from the battery 11 of the vehicle 10, and then outputs the created charge or discharge plan. Specifically, as shown in FIG. 8, the data output section 55 assumes, on the rule curve represented by the rule curve information, a line segment (e.g., a tangent) which is represented by the expression 8 given below and which extends from a point (e.g., a contact point) near a point corresponding to a local maximum value of the accurately predicted estimated necessary electric energy, to thereby estimate and determine an estimated latest charge start time by which charge of the battery 11 of the vehicle 10 must start in order to complete charging of an appropriate amount of electric energy into the battery 11 before coming of a time zone where a maximum amount of electric energy is required; in other words, a time zone where the vehicle 10 travels by consuming the electric energy of the battery 11 more in amount than in other time zones. Notably, the line segment represented by the expression 9 given below is set as a line segment which is tangent to the rule curve in the vicinity of a point corresponding to the local maximum value or a line segment whose value is always greater than the estimated necessary electric energy represented by the rule curve.

$$\theta(t) = F(T(t), V, A) \quad \cdots (8)$$

Notably, the left-hand side $\theta(t)$ of the expression 8 given above represents the amount of electric energy that can be charged into the battery 11 at a time t, T(t) in the expression 8 given above represents the predicted temperature at the time t, V in the expression 8 given above represents the charge voltage, and A in the expression 8 given above represents the charge current. Accordingly, the data output section 55 receives the predicted temperature T(t) which is detected by, for example, an unillustrated ambient temperature sensor provided in the present apparatus or which is externally obtained through communication performed by the communication unit 32; and the charge voltage V and charge current A which are supplied from the charge/discharge station 40 to the battery 11 of the vehicle 10. Subsequently, by use of at least one of the values received as described above, the data output section 55 determines the estimated latest charge start time corresponding to the intersection between the line segment (e.g., a tangent) represented by the expression 8 given above and the line representing the remaining battery energy. Notably, the estimated latest charge start time determined as described above is estimated as the latest charge start time at which charge must been started in order to complete charge before the time at which the local maximum value on the rule curve is reached.

Meanwhile, as shown in FIG. 8, in time zones after the time at which the local maximum value on the rule curve is reached, the estimated necessary electric energy required for running the vehicle 10 decreases. Therefore, for example, in the case where more electric energy than is necessary for running the vehicle 10 is charged in the battery 11 of the vehicle 10; namely, the battery 11 has excessive power, this excessive power may be discharged as the electric power to be used at home. Thus, in the same manner as for the above-described charge plan, the data output section 55 can accurately create a discharge plan for discharging an electric energy from the battery 11 on the basis of the rule curve represented by the rule curve information.

Specifically, as shown in FIG. 8, the data output section 55 assumes, on the rule curve represented by the rule curve information, a line segment (e.g., a tangent) which is represented by the expression 9 given below (configured in the same manner as for the expression 8 given above) and which extends from a point (e.g., a contact point) near a point corresponding to the local maximum value of the accurately predicted estimated necessary electric energy, to thereby estimate and determine an estimated latest discharge stop time at which discharge started in a time zone where the battery 11 has excessive power is completed. Notably, the line segment represented by the expression 9 given below is set as a line segment which is tangent to the rule curve in the vicinity of a point corresponding to the local maximum value or a line segment whose value is always greater than the estimated necessary electric energy represented by the rule curve.

$$\phi(t) = F(T(t), V, A) \quad \cdots (9)$$

Notably, the left-hand side $\phi(t)$ of the expression 9 given above represents the amount of electric energy that can be discharged from the battery 11 at a time t. Accordingly, the data output section 55 receives the predicted temperature T(t), the discharge voltage V supplied from the battery 11, and the discharge current A supplied from the battery 11. Subsequently, by use of at least one of the values received as described above, the data output section 55 determines the estimated latest discharge stop time corresponding to the intersection between the line segment (e.g., a tangent) represented by the expression 9 described above and the line representing the predetermined remaining battery energy.

After determining the estimated latest charge start time in the charge plan and the estimated latest discharge stop time in the discharge plan, the data output section 55 outputs the determined estimated latest charge start time and the estimated latest discharge stop time to, for example, the liquid crystal display unit 35. Thus, the user can extremely easily confirm the charge start time and the discharge start time of the battery 11 of the vehicle 10. Accordingly, for example, by means of electrically connecting the battery 11 of the vehicle 10 to the charge/discharge station 40 by the time the estimated latest charge start time is reached and starting charge at the estimated latest charge start time, the user can finish the operation of charging into the battery 11 an electric energy necessary for running the vehicle 10 before coming of a time zone where the travel distance of the vehicle 10 is long. As a result, the user can act by reliably using the vehicle 10 without worrying about the battery condition during a travel. On the other hand, for example, by means of electrically connecting the battery 11 of the vehicle 10 to the charge/discharge station 40 after completion of a travel, the user can discharge an electric energy from the battery 11 in accordance with the rule curve until the estimated latest discharge stop time is reached. As a result, the user is freed from troublesome operation.

In this case, as described above, the user can cause the present system to automatically implement the charge plan and discharge plan (e.g., determination of the estimated latest charge start time and the estimated latest discharge stop time) determined by the data output section 55 as described above. Specifically, by use of the input unit 34, the user can instruct the electronic control unit 31 of the present apparatus 30 to supply (transmit) to the vehicle-side charge/discharge ECU 23 of the charge/discharge unit 20 of the vehicle 10, for example, the rule curve information representing the rule curve created by the rule curve creation section 54 and the time information representing the estimated latest charge start time and the estimated latest discharge stop time which are determined by and output from the data output section 55. In response to this instruction, the electronic control unit 31 transmits, through use of the communication unit 32, the rule curve information and the time information to the vehicle-side charge/discharge ECU 23 of the charge/discharge unit 20.

The vehicle-side charge/discharge ECU 23 acquires the rule curve information and time information transmitted (supplied) from the present apparatus 30. Next, the vehicle-side charge/discharge ECU 23 transmits the rule curve information and the time information to the power reception/supply ECU 42 of the charge/discharge station 40 through short-range wireless communication. Thus, the power reception/supply ECU 42 of the charge/discharge station 40 installed at, for example, a predetermined parking position in the premises of the user receives the rule curve information and time information transmitted from the vehicle-side charge/discharge ECU 23. Thus, in accordance with the rule curve represented by the received rule curve information and the estimated latest charge start time represented by the time information, the power reception/supply ECU 42 can automatically start charging the electrically connected battery 11 of the vehicle 10 when the estimated latest charge start time is reached. In the case where the vehicle 10 is outside the premises of the user, the power reception/supply ECU 42 of the charge/discharge station 40 installed at a predetermined parking position outside the premises of the user receives the rule curve information and time information transmitted from the vehicle-side charge/discharge ECU 23. Thus, in accordance with the rule curve represented by the received rule curve information and the estimated latest discharge stop time represented by the received time information, the power reception/supply ECU 42 can automatically discharge an electric energy from the electrically connected battery 11 of the vehicle 10 until the estimated latest discharge stop time is reached.

As can be understood from the above description, according to the above-described embodiment, the electronic control unit 31 of the present apparatus 30 (more specifically, the rule curve creation section 54) can create through accurate estimation a rule curve which represents the relation between time (time zone) and an estimated necessary electric energy at each point in time (in each time zone) on the basis of the information concerning the past power consumption of the vehicle 10. Subsequently, on the basis of the rule curve created through accurate estimation, the electrical control unit 31 of the present apparatus 30 (more specifically, the data output section 55) can determine the estimated latest charge start time at which charge of the battery 11 must be started in order to complete the charge of the battery 11 before coming of a time zone (time) where the estimated necessary electric energy necessary for running the vehicle 10 becomes maximum. Further, on the basis of the rule curve created through accurate estimation, the data output section 55 can determine the estimated latest discharge stop time until which an electric energy can be discharged from the battery 11 of the vehicle 10 in the case where the battery has excessive power. Thus, the user can perform charge/discharge control for the vehicle 10 with extreme accuracy and reliability. Accordingly, the user of a vehicle 10 which is a target for such control can reliably use the vehicle with the battery 11 maintained in a good charge condition, thereby enjoying extremely high convenience.

(1) First modification

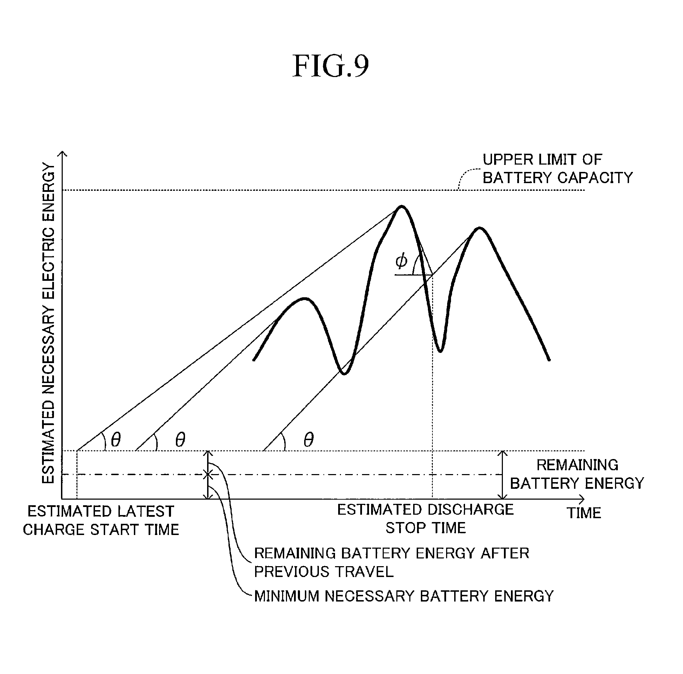

In the above-described embodiment, there has been described the case where the rule curve created by the rule curve creation section 54 has a single local maximum value as shown in FIG. 7. Meanwhile, depending on the travel history of the vehicle 10, as shown in FIG. 9, the rule curve created by the curve creation section 54 may have a plurality of local maximum values. Even in this case, as shown in FIG. 9, just like in the above-described embodiment, the data output section 55 assumes a line segment (e.g., a tangent) which is represented by the expression 8 given above and which extends from a point (e.g., a contact point) near a point representing each local maximum value of the accurately estimated necessary electric energy. Further, the data output section 55 estimates and determines the estimated latest charge start time at which charge of the battery 11 must start in order to complete storage of an appropriate amount of electric energy in the battery 11 before coming of a time zone where a maximum amount of electric energy is required hourly; in other words, a time zone where the vehicle 10 travels by consuming the electric energy of the battery 11 more in amount than in other time zones.

As mentioned above, in the first modification as well, for example, by means of electrically connecting the battery 11 of the vehicle 10 to the charge/discharge station 40 by the time the estimated latest charge start time is reached and by starting charge at the estimated latest charge start time, the user can complete storing in the battery 11 an electric energy necessary for running the vehicle 10 before coming of a time zone where the travel distance of the vehicle 10 becomes long. As a result, the user can act by reliably using the vehicle 10 without worrying about the battery condition during travel. Further, in the first modification as well, just line in the above-described embodiment, by means of receiving the rule curve information and time information, the power reception/supply ECU 42 of the charge/discharge station 40 installed at a predetermined parking position can automatically start charging the electrically connected battery 11 of the vehicle 10 when the estimated latest charge start time is reached. Accordingly, in the first modification as well, the user of the vehicle 10 can reliably use the vehicle with the battery 11 maintained in a good charge condition, thereby enjoying extremely high convenience.

In the first modification in which the rule curve has a plurality of local maximum values, in the case where the battery 11 of the vehicle 10 has excessive power, an electric energy can also be discharged from the battery 11 as shown in FIG. 9. In the first modification, just like in the above-described embodiment, the data output section 55 assumes a line segment (e.g., a tangent) which is represented by the expression 9 given above and which extends from a point (e.g., a contact point) near a point representing each local maximum value of the accurately estimated necessary electric energy. However, the first modification is slightly different from the above-described embodiment in that, in the case where there is a line segment which extends from a point which is near a point representing an adjacent local maximum value, discharge stops at a time (an estimated discharge stop time) corresponding to the intersection between the above-described two line segments.

As described above, in the first modification as well, by electrically connecting the battery 11 of the vehicle 10 to the charge/discharge station 40 after running the vehicle 10, the user can discharge electric energy from the battery 11 in accordance with the rule curve until the estimated discharge stop time is reached. As a result, the user is freed from troublesome operation. Further, in the first modification as well, just line in the above-described embodiment, in accordance with the rule curve and the estimated discharge stop time represented by the time information, the power reception/supply ECU 42 of the charge/discharge station 40 can automatically discharge an electric energy from the electrically connected battery 11 of the vehicle 10 until the estimated latest discharge stop time is reached. Accordingly, in the first modification as well, the user of the vehicle 10 can get extremely high convenience.

(2) Second modification

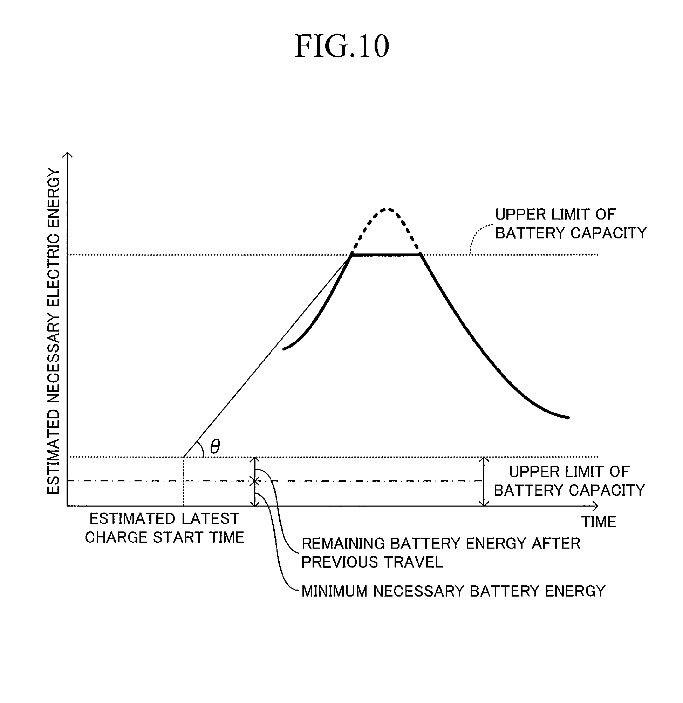

In the above-described embodiment and the first modification, an explanation has been provided assuming the case where the estimated necessary electric energy represented by the rule curve, which is created by the rule curve creation section 54, is as high as or lower than the upper limit of the battery capacity of the battery 11 of the vehicle 10. In this case, as shown in FIG. 10, the estimated necessary electric energy represented by the rule curve, which is created on the basis of the past travel history of the vehicle 10, may exceed the upper limit of the battery capacity due to, for example, natural deterioration of the battery 11. Notably, the change in the upper limit of the battery capacity may be estimated in a well-known manner.

Accordingly, in the second modification, as shown in FIG. 10, in the case where the local maximum value of the estimated necessary electric energy represented by the rule curve, which is created by the rule curve creation section 54, exceeds the upper limit of the battery capacity, the data output section 55 assumes a line segment (e.g., a tangent) which is represented by the expression 8 given above and which extends from a point where the estimated necessary electric energy coincides with the upper limit of the battery capacity. Further, the data output section 55 estimates and determines the estimated latest charge start time at which charge of the battery 11 must start in order to charge an appropriate amount of electric energy into the battery 11 before coming of a time zone where a maximum amount of electric energy is required; in other words, a time zone where the vehicle 10 travels by consuming the electric energy of the battery 11 more in amount than in other time zones. Further, although not illustrated in FIG. 10, the data output section 55 assumes a line segment (e.g., a tangent) which is represented by the above-described expression 9 and which extends from a point where the estimated necessary electric energy coincides with the upper limit of the battery capacity, and estimates an determines the discharge stop time at which discharge started in a time zone where the battery 11 has excessive power is completed.

As described above, in the second modification as well, just like in the above-described embodiment and the first modification, for example, by means of electrically connecting the battery 11 of the vehicle 10 to the charge/discharge station 40 by the time the estimated latest charge start time is reached and starting charge at the estimated latest charge start time, the user can finish the operation of charging into the battery 11 an electric energy necessary for running the vehicle 10 before coming of the time zone where the travel distance of the vehicle 10 is long. As a result, the user can act by reliably using the vehicle 10 without worrying about the battery charge condition during the travel. Further, in the second modification as well, just like in the above-described embodiment and the first modification, for example, by means of electrically connecting the battery 11 of the vehicle 10 to the charge/discharge station 40 after running the vehicle 10, the user can discharge electric energy from the battery 11 in accordance with the rule curve until the estimated latest discharge stop time is reached. As a result, the user is freed from troublesome operation. Further, in the second modification as well, just like in the above-described embodiment and the first modification, in accordance with the rule curve or the estimated latest charge start time or estimated discharge stop time represented by the time information, the power reception/supply ECU 42 of the charge/discharge station 40 can automatically start charging the electrically connected battery 11 of the vehicle 10 when the estimated latest charge start time is reached. Further, the power reception/supply ECU 42 of the charge/discharge station 40 can also automatically discharge an electric energy from the electrically connected battery 11 of the vehicle 10 until the estimated latest discharge stop time is reached. Accordingly, in the second modification as well, the user of the vehicle 10 can get extremely high convenience.

(3) Third modification

In the above-described embodiment and the above-described first and second modifications, there has been described only the case where only the vehicle 10 is the target for charge/discharge control. Incidentally, for example, there are a case where the user owns a plurality of plug-in-type vehicles such as the vehicle 10 and charges these vehicles and a case where a home appliance(s) must be charged together with the vehicle 10 in an ordinary house having only a limited commercial power capacity due to an electricity contract. In these cases, preferably, the charge start time is determined, for example, in accordance with a priority applied when the vehicle 10 is used along with a home appliance(s), in other words, in accordance with the charge priority. Therefore, in the third modification, the charge start time is determined in accordance with the charge priority.

In the third embodiment, the vehicle 10 is referred to as a to-be-charged apparatus 1, a home appliance is referred to as a to-be-charged apparatus 2, and there will be described, as an example, a case where the ratio of priority between the to-be-charged apparatus 1 (the vehicle 10) and the to-be-charged apparatus 2 (the home appliance) is set to 2:1. Needless to say, the ratio of priority may be appropriately set by the user.

In the third modification, the rule curve creation section 54 creates a rule curve for the home appliance; namely, the to-be-charged apparatus 2. In this case, the rule curve creation section 54 may create a rule curve representing the relation between time (time zone) and an estimated necessary electric energy at each point in time (in each time zone) on the basis of, for example, information concerning the past power consumption output from the home appliance.

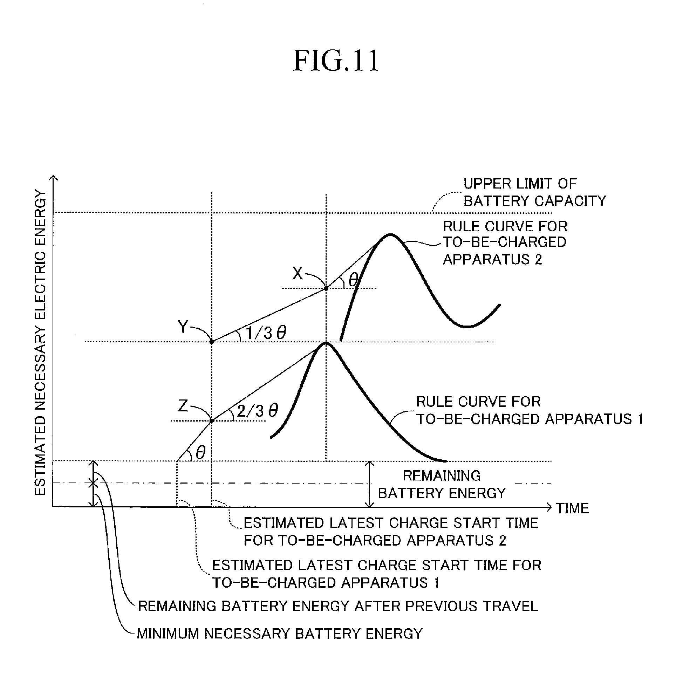

In the third modification, as shown in FIG. 11, the data output section 55 estimates and determines an estimated latest charge start time for each of the rule curves for the to-be-charged apparatus 1 and to-be-charged apparatus 2. Specifically, the data output section 55 sets a line segment (e.g., a tangent) which is represented by the expression 8 given above and which extends from a point (e.g., a contact point) near a point (on the rule curve for the to-be-charged apparatus 2 given low priority) corresponding to the local maximum value. Further, the data output section 55 determines the intersection X between the set line segment (e.g., a tangent) and a vertical line representing the time at which the rule curve for the to-be-charged apparatus 1 reaches the local maximum value. Further, as shown in FIG. 11, the data output section 55 sets a line segment (e.g., a tangent) which extends from the intersection X at an angle obtained by multiplying by 1/3 the chargeable amount $\theta(t)$ represented by the expression 8 given above in accordance with the ratio of priority. Further, the data output section 55 determines the intersection Y between the set line segment (e.g., a tangent) and the horizontal line corresponding to the local maximum value reached by the rule curve for the to-be-charged apparatus 1. Finally, as shown in FIG. 11, the data output section 55 determines a time corresponding to the intersection Y as the estimated latest charge start time of the to-be-charged apparatus 2.

For the to-be-charged apparatus 1 given high priority, as shown in FIG. 11, the data output section 55 sets a line segment (e.g., a tangent) which extends from a point (e.g., a contact point) near a point (on the rule curve for the to-be-charged apparatus 1) corresponding to the local maximum value at an angle obtained by multiplying by 2/3 the chargeable amount θ(t) represented by the expression 8 given above in accordance with the ratio of priority. Further, as shown in FIG. 11, the data output section 55 determines the intersection Z between the set line segment (e.g., a tangent) and the vertical line representing the estimated latest charge start time of the to-be-charged apparatus 2. Finally, the data output section 55 sets a line segment (e.g., a tangent) which extends from this intersection Z and is represented by the expression 8 given above. Thus, the data output section 55 determines, as the estimated latest charge start time for the to-be-charged apparatus 1, the intersection between the line segment (e.g., a tangent) represented by the expression 8 given above and the horizontal line representing the predetermined remaining battery energy. Notably, the estimated latest discharge stop time according to the third modification is determined just like the estimated latest charge start time which is determined in consideration of the above-described priority.

As mentioned above, in the third modification, in the case where there are a plurality of pieces of equipment to be charged, charge of these pieces of equipment can be appropriately completed in accordance with the priority therebetween just like the above-described embodiment and the first and second modifications. Other expected effects are similar to those of the above-described embodiment and the first and second modifications.

The present invention is not limited to the above-described embodiment and modifications, and various modifications are possible without departing from the scope of the present invention.

For example, in the above-described embodiment and modifications, the rule curve creation section 54 creates a rule curve by use of a departure-time-zone-specific predicted travel distance map that the travel distance prediction map generation section 53 has created by the departure/arrival time prediction map generation section 52 through, for example, statistical processing performed by use of the predicted departure time map created in accordance with the expression 1 given above and the travel distance of the vehicle 10. As a result, the rule curve creation section 54 can create a rule curve on the basis of the state of use of the vehicle 10 which is predicted with extreme accuracy, thereby allowing the data output section 55 to determine a charge/discharge plan with extreme accuracy.

In this case, needless to say, the rule curve creation section 54 can create a rule curve by use of, for example, the predicted departure time map created by the departure/arrival time prediction map generation section 52 and the travel distance supplied from the data input section 51. In this case, if travel distance data represented by the travel distance information exists, the rule curve creation section 54 can create a rule curve with slight reduction in accuracy, thereby allowing the data output section 55 to determine the estimated latest charge start time and the estimated latest discharge stop time by use of this rule curve.

In addition, the electric control unit 31 can control charge and discharge of the electrically connected battery 11 of the vehicle 10 by use of the predicted departure time map and the predicted arrival time map created by the departure/arrival time prediction map generation section 52. Namely, in this case, by use of the accurately created predicted arrival time map, the data output section 55 identifies the time at which the vehicle 10 (the target for charge/discharge) is likely to be parked at a predetermined parking position (i.e., the time at which the probability of occurrence (safety probability) $P_{th}$ is equal to or higher than a predetermined safety probability (e.g., 90%)). Notably, the predetermined safety probability may be set in advance or changed appropriately. By means of identifying the time (time zone) at which the vehicle 10 is likely to be parked at the predetermined parking position as described above, the data output section 55 can instruct the user to supply electric energy to the battery 11 of the vehicle 10 or discharge an electric energy from the battery 11 of the vehicle 10 after the identified time (time zone).

Meanwhile, by use of the accurately created predicted departure time map, the data output section 55 identifies the time at which the vehicle 10 (the target for charge/discharge) is likely to depart from the predetermined parking position (i.e., the time at which the probability of occurrence (safety probability) $P_{th}$ is equal to or higher than a predetermined safety probability (e.g., 90%)). By means of identifying the time (time zone) at which the vehicle 10 is likely to depart from the predetermined parking position as described above, the data output section 55 can instruct the user to supply electric energy to the battery 11 of the vehicle 10 or discharge an electric energy from the battery 11 of the vehicle 10 by the time the identified time (time zone) is reached.

Further, in the above-described embodiment and modifications, upon determination of an estimated latest charge start time and an estimated latest discharge stop time by the data output section 55, the battery 11 of the vehicle 10 is electrically connected to the charge/discharge station 40, and charge is started at the determined estimated latest charge start time or discharge is stopped at the determined estimated latest discharge stop time. However, in particular, in the case where the user (or the power reception/supply ECU 42 of the charge/discharge station 40) does not start charge at the determined estimated latest charge start time for some reason or in the case where the user sets by himself or herself a charge start time which is later than the estimated latest charge start time for some reason, the electronic control unit 31 (more specifically, the data output section 55) of the present apparatus 30 can notify, via the liquid crystal display unit 35, the user that the battery 11 may not be charged sufficiently such that the battery 11 has an estimated necessary electric energy.

Further, after notifying, via the liquid crystal display unit 35, the user that the battery 11 may not be charged sufficiently such that the battery 11 has an estimated necessary electric energy, the electronic control unit 31 (more specifically, the data output section 55) of the present apparatus 30 can prevent the user from setting a charge start time by himself or herself. Thus, an estimated necessary electric energy can be certainly stored in the battery 11 through charge.

**Claims**

1. A charge/discharge assist device comprising control means for assisting charge or discharge of a battery installed in a piece of equipment, the charge/discharge assist device being **characterized in that**
the control means
acquires information concerning past consumption of power of the battery in the equipment,
creates a rule curve representing a relation between time and an estimated necessary electric energy at each point in time which must be reserved before that time on the basis of the acquired information concerning the past consumption of power of the battery in the equipment,
estimates and determines a charge start time at which charge of the battery is to be started or a discharge stop time at which discharge of the battery is to be stopped, by use of the created rule curve, and
outputs the estimated and determined charge start time or discharge stop time.

2. A charge/discharge assist device according to claim 1, wherein the control means estimates and determines a latest charge start time which is a latest time at which charge of the battery is to be started or a latest discharge stop time which is a latest time at which discharge of the battery is to be stopped, through use of the created rule curve, by setting a line segment which is tangent to the rule curve in the vicinity of a point corresponding a local maximum value of the rule curve or a line segment whose value is always greater than the estimated necessary electric energy represented by the rule curve.

3. A charge/discharge assist device according to claim 2, wherein when the created rule curve has a plurality of local maximum values, the control means sets line segments each of which is tangent to the rule curve in the vicinity of a point representing the corresponding local maximum value or line segments each of which has a value which is always greater than the estimated necessary electric energy represented by the rule curve, estimates and determines latest charge start times or latest discharge stop times by using the line segments, and outputs the earliest one of the latest charge start times or the latest one of the latest discharge stop times .

4. A charge/discharge assist device according to claim 2 or 3, wherein when the estimated power consumption represented by the created rule curve exceeds an upper limit of the battery capacity of the battery, the control means sets a line segment that passes through a point at which the estimated necessary electric energy coincides with the upper limit of the battery capacity or a line segment whose value is always greater than the estimated necessary electric energy represented by the rule curve, to thereby estimate and determine the latest charge start time, or the control means sets a line segment which passes through the point or a line segment whose value is always greater than the estimated necessary electric energy represented by the rule curve, to thereby estimate and determine the latest discharge stop time.

5. A charge/discharge assist device according to any one of claims 2 to 4, wherein the control means sets the line segment for estimating and determining the latest charge start time by use of at least one of an amount of electric energy that can be stored in the battery, a predicted ambient temperature at the time when the battery is charged, a charge voltage supplied to the battery, and a charge current supplied to the battery, or the control means sets the line segment for estimating and determining the latest discharge stop time by use of at least one of an amount of electric energy that can be discharged from the battery, a predicted ambient temperature at the time when the battery is charged, a discharge voltage supplied from the battery, and a discharge current supplied from the battery.

6. A charge/discharge assist device according to any one of claims 1 to 5, wherein
the equipment is a plug-in-type electric vehicle whose battery is charged by an external power supply, and
the control means creates a rule curve representing a relation between time and an estimated necessary electric energy at each point in time which must be reserved before that time on the basis of the information concerning the past consumption of power of the battery in the plug-in-type electric vehicle.

7. A charge/discharge assist device according to claim 6, wherein the information concerning the past consumption of power of the battery in the plug-in-type electric vehicle is departure time information indicating a time at which the plug-in-type electric vehicle departed from a predetermined parking position and arrival time information indicating a time at which the plug-in-type electric vehicle arrived at the predetermined parking position, or the information concerning the past consumption of power of the battery in the plug-in-type electric vehicle is travel distance information indicating a travel distance that the plug-in-type electric vehicle has traveled after it departed from the predetermined parking position at the departure time indicated by the departure time information.

8. A charge/discharge assist device according to any one of claims 1 to 5, wherein the control means creates rule curves for a plurality of pieces of equipment, each of which represents a relation between time and an estimated necessary electric energy at each point in time which must be reserved before that time, on the basis of information concerning the past consumption of power of the battery in each of the plurality of pieces of equipment, estimates and determines a charge start time at which charge of the battery is to be started or a discharge stop time at which discharge of the battery is to be stopped, by use of the created rule curves and in consideration of priority among the plurality of pieces of equipment when they are used, and outputs the estimated and determined charge start time or discharge stop time.

9. A charge/discharge assist device according to claim 8, wherein, in consideration of the priority among the plurality of pieces of equipment, the control means sets line segments each of which is tangent to the corresponding created rule curve in the vicinity of a point corresponding to a local maximum value of the rule curve or line segments each of which has a value which is always greater than the estimated necessary electric energy represented by the rule curve, to thereby estimate and determine the latest charge start time or the latest discharge stop time.

FIG.1

# FIG.2

# FIG.3

DB ⌐33a
- DEPARTURE TIME INFORMATION
- ARRIVAL TIME INFORMATION
- TRAVEL DISTANCE INFORMATION
- POWER CONSUMPTION INFORMATION

⌐11

⌐51
DATA INPUT SECTION

- POWER CONSUMPTION INFORMATION

- DEPARTURE TIME INFORMATION
- ARRIVAL TIME INFORMATION

- TRAVEL DISTANCE INFORMATION

⌐52
DEPARTURE/ARRIVAL TIME PREDICTION MAP GENERATION SECTION

- PREDICTED DEPARTURE TIME INFORMATION

⌐53
TRAVEL DISTANCE PREDICTION MAP GENERATION SECTION

- DEPARTURE-TIME-ZONE-SPECIFIC PREDICTED TRAVEL DISTANCE MAP

- PREDICTED DEPARTURE TIME MAP
- PREDICTED ARRIVAL TIME MAP

⌐54
RULE CURVE CREATION SECTION

- RULE CURVE INFORMATION

⌐55
DATA OUTPUT SECTION

- ESTIMATED LATEST CHARGE START TIME
- ESTIMATED LATEST DISCHARGE STOP TIME

⌐35

EP 2 752 962 A1

# FIG.4

CUMULATIVE PROBABILITY OF OCCURRENCE (SAFETY PROBABILITY)

ARRIVAL TIME (HOLIDAYS)

ARRIVAL TIME (WEEKDAYS)

DEPARTURE TIME (HOLIDAYS)

DEPARTURE TIME (WEEKDAYS)

DEPARTURE/ARRIVAL TIME

# FIG.5

CUMULATIVE PROBABILITY OF OCCURRENCE (SAFETY PROBABILITY)

10 TO 11 AM

8 TO 9 AM

9 TO 10 AM

TRAVEL DISTANCE

# FIG.6

※VERTICAL AXIS: CUMULATIVE FREQUENCY
HORIZONTAL AXIS: TRAVEL DISTANCE

# FIG.7

# FIG.8

# FIG.9

# FIG.10

# FIG.11

## INTERNATIONAL SEARCH REPORT

| International application No. |
|---|
| PCT/JP2012/072207 |

**A. CLASSIFICATION OF SUBJECT MATTER**
*H02J7/00*(2006.01)i, *B60L11/18*(2006.01)i, *H01M10/44*(2006.01)i

According to International Patent Classification (IPC) or to both national classification and IPC

**B. FIELDS SEARCHED**

Minimum documentation searched (classification system followed by classification symbols)
H02J7/00, B60L11/18, H01M10/44

Documentation searched other than minimum documentation to the extent that such documents are included in the fields searched
Jitsuyo Shinan Koho          1922–1996    Jitsuyo Shinan Toroku Koho    1996–2012
Kokai Jitsuyo Shinan Koho    1971–2012    Toroku Jitsuyo Shinan Koho    1994–2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 4164996 B1  (Nissan Motor Co., Ltd.), 08 August 2008 (08.08.2008), claim 1; paragraphs [0023], [0055] to [0081]; fig. 1, 5, 6 (Family: none) | 1-9 |
| A | JP 2010-81722 A  (Hitachi, Ltd.), 08 April 2010 (08.04.2010), paragraphs [0036] to [0040] & US 2010/0076825 A1 | 1-9 |
| A | WO 2010/084598 A1  (Toyota Motor Corp.), 29 July 2010 (29.07.2010), paragraphs [0074] to [0079]; fig. 5 to 7 (Family: none) | 1-9 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 November, 2012 (26.11.12) | 04 December, 2012 (04.12.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2012/072207 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2003-47168 A (Nippon Telegraph and Telephone Corp.), 14 February 2003 (14.02.2003), paragraphs [0007] to [0019]; fig. 1 to 4 (Family: none) | 1-9 |

Form PCT/ISA/210 (continuation of second sheet) (July 2009)

**EP 2 752 962 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010081722 A
- JP 2011083165 A
- JP 4164996 B